# EUROPÄISCHE PATENTSCHRIFT

(11) **EP 0 891 828 B1**
(45) Veröffentlichungstag und Bekanntmachung des Hinweises auf die Patenterteilung: **05.01.2000**
(21) Anmeldenummer: 98108403.1
(22) Anmeldetag: 08.05.1998
(51) Int. Cl.: B22D 27/04, C30B 11/00

(54) **Verfahren zum gerichteten Erstarren einer Metallschmelze und Giessvorrichtung zu seiner Durchführung**
Method and apparatus for directional solidification of a metal melt
Procédé et dispositif pour la coulée par solidification dirigée de métal en fusion

(30) Priorität: 17.07.1997 DE 19730637
(43) Veröffentlichungstag der Anmeldung: 20.01.1999
(73) Patentinhaber: ALD Vacuum Technologies GmbH, 63526 Erlensee (DE)
(72) Erfinder: Hugo, Franz, 63743 Aschaffenburg (DE)

(56) Entgegenhaltungen:
- EP-A- 0 631 832

## Beschreibung

De Erfindung betrifft ein Verfahren zum gerichteten Erstarren einer in eine Gießform eingegossenen Metallschmelze, beispielsweise Nickel, durch Herausbewegen der Gießform aus einer Heizkammer und Eintauchen der Gießform in ein als Kühlschmelze dienendes, von einer Wärmeisolationsschicht abgedecktes Flüssigmetallbad niedrigeren Schmelzpunktes als die Metallschmelze in der Gießform, beispielsweise Aluminium. Weiterhin betrifft die Erfindung eine Gießvorrichtung zur Durchführung dieses Verfahrens.

Ein solches Verfahren und solche Gießvorrichtungen sind Gegenstand der DE-A-28 15 818. Das Eintauchen der Gießform in die Kühlschmelze dient dazu, durch einen intensiven, axialen Wärmefluß beim Erstarren des Gußteils in der Gießform eine Fest-Flüssig-Zone möglichst geringer Höhe und eine möglichst ebene, quer zur Haupterstreckungsrichtung des Gußteils verlaufende Phasengrenze zwischen fest und flüssig zu erreichen, damit die Kristalle axial in das Gußstück hineinwachsen. Diese Zielrichtung erfordert es, die radiale Abstrahlung von Wärme oberhalb der Kühlschmelze möglichst gering zu halten. Hierzu ist bei der bekannten Gießvorrichtung an der Unterseite der Heizkammer ein zur Gießform hin gerichteter, allgemein als Baffle bezeichneter Strahlungsschirm vorgesehen. Zusätzlich schwimmt auf der Kühlschmelze eine Trennplatte aus einem wärmeisolierenden Material, welche zum Eintauchen der Gießform in die Kühlschmelze eine Öffnung hat. Die Wärmedämmung ist jedoch nur unvollkommen, insbesondere dann, wenn die Gußteile mehrere nach unten gerichtete Teile aufweisen, da dann der Strahlungsschirm und die Trennplatte die Bereiche zwischen diesen Teilen nicht erreichen können. Hiervon abgesehen verbleibt zwangsläufig zwischen der Gießform und dem Strahlungsschirm sowie der Gießform und der Trennplatte ein Spalt, durch den Wärme abgestrahlt wird.

Die DE-B-19 53 716 zeigt auch schon zum Eintauchen einer Gießform mit einer abzukühlenden Metallschmelze einen Behälter mit einer Kühlschmelze, dessen Oberfläche durch eine wärmeisolierende Schicht abgedeckt ist. Diese Schicht hat den Sinn, ein Oxydieren oder ein übermäßig starkes Abkühlen der Kühlschmelze zu verhindern. Die Gießform durchdringt beim Eintauchen in die Kühlschmelze diese wärmeisolierende Schicht. Sie wird allerdings nicht aus einer Heizkammer herausbewegt.

Durch die DE-B-22 42 111 ist es bei einem gattungsgemäßen Verfahren bekannt, die Oberfläche der Kühlschmelze so dicht unterhalb der Heizkammer vorzusehen, daß die Kühlplatte der Gießform vor dem Eintauchen der Gießform zumindest teilweise in die Kühlschmelze eintaucht. Hierdurch ist die Kühlplatte schon beim Füllen der Gießform durch die Kühlschmelze gekühlt, so daß sie eine besonders gute Kühlwirkung ausübt. Zur Vermeidung von Wärmeverlusten zwischen dem unteren Ende der Heizkammer und der Gießform ist bei der Vorrichtung nach der DE-B-22 42 111 ein Hitzeschild vorgesehen.

Bekannt ist weiterhin (EP 0 571 703 A1) ein Verfahren zur Herstellung eines metallischen Gußkörpers nach dem Feingußverfahren, insbesondere eines Gußkörpers aus Aluminium oder aus einer aluminiumhaltigen Legierung durch Gießen einer Schmelze eines Metalls in eine Gießform aus Keramik mit porösen Wänden und Abkühlung und Erstarren der Schmelze unter Verwendung eines Kühlmittels, wobei als Kühlmittel eine die Gießform-Wand allmählich penetrierende Kühlflüssigkeit eingesetzt wird, deren Siedetemperatur niedriger als die Eingießtemperatur der Schmelze ist und in die die Gießform von einem Ende aus beginnend stetig eingetaucht wird, derart, daß die als Grenzfläche zwischen Schmelze und bereits erstarrtem Metall sich bildende Erstarrungsfront und der Penetrationsbereich, in dem die Gießform-Wand von der Kühlflüssigkeit über ihre Dicke durchdrungen ist, sich im wesentlichen in Richtung der freien Schmelzenoberfläche bewegen, wobei die Eintauchgeschwindigkeit der Gießform in die Kühlflüssigkeit, die Dicke und die Porosität der Gießform-Wand sowie die Viskosität und die Dichte der Kühlflüssigkeit so aufeinander abgestimmt sind, daß in Bewegungsrichtung der Erstarrungsfront gesehen, der Penetrationsbereich der Erstarrungsfront nacheilt.

Schließlich ist ein Verfahren zum gerichteten Erstarren einer in eine Gießform gegossenen Metallschmelze, beispielsweise Nickel durch Herausbewegen der Gießform aus einer Heizkammer und eintauchen der Gießform in ein als Kühlschmelze dienendes Flüssigmetallbad niedrigeren Schmelzpunktes als die Metallschmelze in der Gießform, beispielsweise Aluminium bekannt (EP 0 631 832 A1), bei dem zur Abdichtung zwischen der Heizkammer und der Gießform auf der Kühlschmelze eine schwimmende, aus einem fließfähigen Material bestehende Wärmeisolationsschicht aufgegeben und bevor die Gießform die Wärmeisolationsschicht durchdringt und in die Kühlschmelze eintaucht, die Heizkammer oder die Kühlschmelze so weit verfahren wird, daß die Heizkammer die Wärmeisolationsschicht berührt oder in sie eintaucht. Die Wärmeisolationsschicht besteht in diesem Falle aus einem Granulat aus Graphit, Keramik oder Aluminiumoxyd mit einer eine Benetzung ausschließenden Beschichtung, wobei als Beschichtung Bornitrid verwendet wird.

Der Erfindung liegt das Problem zugrunde, ein Verfahren der eingangs genannten Art derart weiterzuentwickeln, daß die auf der Metallschmelze schwimmende Wärmeisolationsschicht sich unter allen Bedingungen als eine fließfähige, in ihrer Konsistenz gleichförmige Masse verhält und nicht zur Klumpenbildung, Versinterung oder andersartigen örtlichen Verfestigung neigt.

Diese Aufgabe wird nach der Erfindung durch einen in die Wärmeisolationsschicht eintauchenden, von einem Rüttelgerät oder Schwingungserzeuger bewegten Rechen, Paddel oder Rührer gelöst, wobei das Rüttelgerät, der Schwingungserzeuger oder Antriebsaggregat am oberen Rand des Tiegels fest angeordnet ist und der Rechen, Paddel oder Rührer mit dem sich hin- und herbewegenden Antrieb in Wirkverbindung steht.

Weitere Einzelheiten sind in den Patentansprüchen näher gekennzeichnet und beschrieben.

Die Erfindung läßt zahlreiche Ausführungsformen zu. Zur Verdeutlichung ihres Grundprinzips ist eine davon in den Zeichnungen dargestellt und nachfolgend beschrieben. Diese zeigen in
- Fig. 1: einen schematischen Längsschnitt durch eine Gießvorrichtung nach der Erfindung mit einer in eine Heizkammer eingefahrene Gießform,
- Fig. 2: einen der Fig. 1 entsprechenden Schnitt mit teilweise aus der Heizkammer in eine Kühlschmelze gefahrener Gießform.

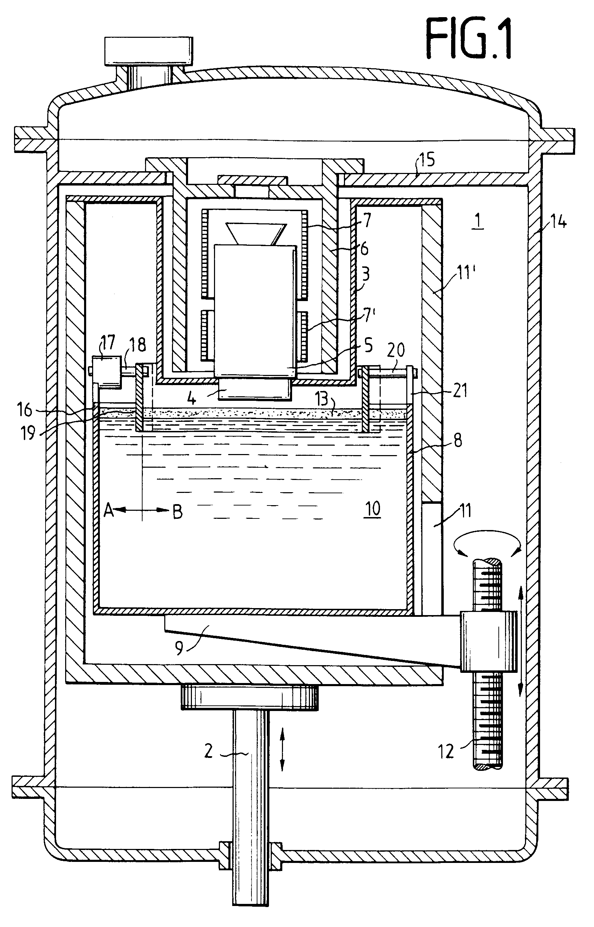

Die Fig. 1 zeigt eine Hubkammer 1, welche auf einem Stempel 2 angeordnet ist und durch Verfahren des Stempels 21 nach oben oder unten bewegt werden kann. Von oben her ragt ein auf der Hubkammer 1 abgestütztes Haltegestell 3 in die Hubkammer 1 hinein, bei dem es sich um ein korbartiges Gebilde aus Graphit handeln kann. Auf diesem Haltegestell 3 ist eine Kühlplatte 4 abgestützt, die den Boden einer Gießform 5 bildet. In der dargestellten Gießposition ist die Gießform 5 vollständig in eine Heizkammer 6 eingefahren, welche elektrische Heizelemente 7,7' enthält, die die Gießform ringförmig umgeben.

Unterhalb der Heizkammer 6 ist ein Tiegel 8 auf einem Träger 9 angeordnet, welcher eine Kühlschmelze 10 enthält. Der Träger 9 führt durch einen Schlitz 11 der Hubkammer 1 nach außen und ist auf einer als Spindeltrieb ausgebildeten Vertikalführung 12 höhenverfahrbar. Wichtig für die Erfindung ist eine beispielsweise aus Aluminiumoxyd in Pulver- oder Granulatform bestehende Wärmeisolationsschicht 13, welche auf der Kühlschmelze 10 schwimmt.

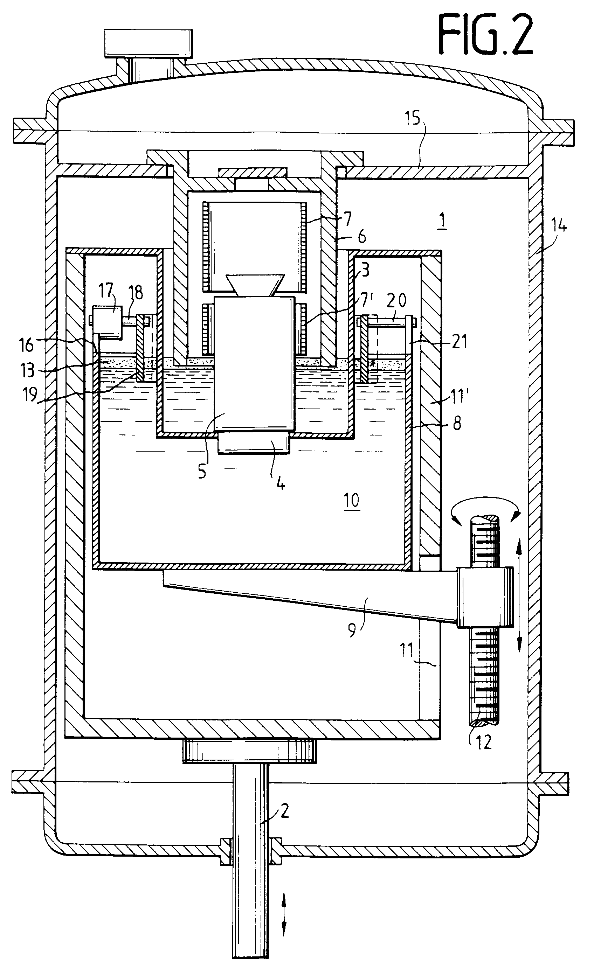

Wenn die Gießform 5 mit flüssigem Metall gefüllt ist und man mit der gerichteten Erstarrung beginnen will, dann fährt man zunächst durch Hochfahren des Trägers 9 auf der Vertikalführung 12 den Tiegel 8 mit der Kühlschmelze 10 so weit nach oben, bis die Unterkante der Heizkammer 6 geringfügig in die Wärmeisolationsschicht 13 eintaucht, so daß eine optische Trennung zwischen dem Inneren der Heizkammer 6, also dem Heizraum und dem Kühlraum, also der Kühlschmelze 10 entsteht. Anschließend beginnt man damit, den Stempel 2 abwärts zu bewegen. dadurch senkt sich die Hubkammer 1 mit dem Haltegestell 3 ab, so daß die Gießform 5 zunehmend die Wärmeisolationsschicht 13 durchdringt und in die Kühlschmelze 10 eintaucht, was in Fig. 2 dargestellt ist. Diese Abwärtsbewegung der Hubkammer 1 setzt man so lange fort, bis die Gießform 5 vollständig in die Kühlschmelze 10 eingetaucht und das Gußteil in ihr dadurch erstarrt ist.

In den Fig. 1 und 2 ist zusätzlich gezeigt, daß die gesamte Gießvorrichtung auf übliche Weise in einer Vakuumkammer 14 angeordnet ist. Diese hat einen nach innen gerichteten, flanschartigen Bund 15, auf dem die Heizkammer 6 abgestützt ist. Nicht gezeigt ist ein in der Vakuumkammer 14 angeordneter, schwenkbarer Tiegel, aus dem die Metallschmelze nach Öffnen eines Deckels 16 in die Gießform 5 gegossen werden kann.

Um sicher zu stellen, daß sich die beispielsweise aus einem Granulat aus Graphit, Keramik oder Aluminiumoxyd mit einer eine Benetzung ausschließenden Beschichtung bestehende Wärmeisolationsschicht 13 stets über die gesamte Oberfläche der Schmelze 10 gleichmäßig verteilt und sich auch die Schichtzusammensetzung nicht während des Betriebs verändert, also z. B. kein Zusammensintern der Schicht 13 erfolgt, ist auf dem oberen Rand 16 des Tiegels 8 ein motorisch betriebenes Rüttelgerät oder ein Schwingungserzeuger 17 fest angeordnet, der über eine Arm oder Stößel 18 einen Ring 19 in Pfeilrichtung A-B horizontal hin- und herbewegt. Dieser Ring 19 kann aus einem perforierten Blechzuschnitt gebildet sein oder aber auch ein solider Kreisringzylinder sein. Um ein Abkippen des Rings 19 in die Schmelze 10 zu verhindern, ist der Ring 19 über einen sich von diesem radial nach außen hin erstreckenden Bolzen 20 in einer Bohrung gehalten und geführt, die in einem sich vom Rand 16 des Tiegels 8 aus lotrecht erstreckenden Arm 21 vorgesehen ist.

### Bezugszeichenliste

- 1: Hubkammer
- 2: Stempel
- 3: Haltegestell
- 4: Kühlplatte
- 5: Gießform
- 6: Heizkammer
- 7: Heizelement
- 8: Tiegel
- 9: Träger
- 10: Kühlschmelze
- 11: Schlitz
- 12: Vertikalführung
- 13: Wärmeisolationsschicht
- 14: Vakuumkammer
- 15: Bund
- 16: Tiegelrand
- 17: Rüttelgerät, Schwingungserzeuger
- 18: Stößel, Arm, Abtriebsglied
- 19: Ring
- 20: Bolzen
- 21: Arm

## Patentansprüche

1. Verfahren zum gerichteten Erstarren einer in eine Gießform gegossenen Metallschmelze, beispielsweise Nickel, durch Herausbewegen der Gießform aus einer Heizkammer und Eintauchen der Gießform in ein als Kühlschmelze dienendes Flüssigmetallbad niedrigeren Schmelzpunktes als die Metallschmelze in der Gießform, beispielsweise Aluminium, wobei zur Abdichtung zwischen der Heizkammer und der Gießform auf der Kühlschmelze eine schwimmende, aus einem fließfähigen Material bestehende Wärmeisolationsschicht aufgegeben wird und bevor die Gießform die Wärmeisolationsschicht durchdringt und in die Kühlschmelze eintaucht, die Heizkammer oder die Kühlschmelze so weit verfahren wird, daß die Heizkammer die Wärmeisolationsschicht berührt oder in sie eintaucht, **dadurch gekennzeichnet**, daß die Wärmeisolationsschicht von einem motorisch angetriebenen Rechen, Paddel oder Rührer lebhaft bewegt oder verquirlt wird.

2. Vorrichtung zum gerichteten Erstarren einer in eine Gießform (5) gegossenen Metallschmelze, beispielsweise Nickel, durch Herausbewegen der Gießform (5) aus einer Heizkammer (6) und Eintauchen der Gießform (5) in ein als Kühlschmelze dienendes Flüssigmetallbad (10) niedrigeren Schmelzpunktes als die Metallschmelze in der Gießform (5), beispielsweise einem Aluminiumschmelzbad, wobei zur Abdichtung zwischen der Heizkammer (6) und der Gießform (5) auf die Kühlschmelze (10) eine schwimmende, aus einem fließfähigen Material bestehende Wärmeisolationsschicht (13) aufgegeben ist, und bevor die Gießform die Wärmeisolationsschicht (13) durchdringt und in die Kühlschmelze (10) eintaucht, die Heizkammer (6) oder die Kühlschmelze (10) so weit verfahren wird, daß die Heizkammer (6) die Wärmeisolationsschicht (13) berührt oder in sie eintaucht, **gekennzeichnet durch** einen in die Wärmeisolationsschicht (13) eintauchende, von einem Rüttelgerät oder Schwingungserzeuger (17) bewegten Rechen oder Rührer (19), wobei das Rüttelgerät oder der Schwingungserzeuger (17) am oberen Rand (16) des Tiegels (8) für die Kühlschmelze (10) fest angeordnet ist und der Rechen oder Rührer (19) mit dem sich hin- und herbewegenden Abtriebsglied (18) des Rüttelgeräts oder Schwingungserzeugers (17) in Wirkverbindung steht.

3. Vorrichtung nach Anspruch 2, **dadurch gekennzeichnet**, daß der Rechen oder Rührer (19) als ein die Gießform (5) umschließender Ring (19) ausgebildet ist, der vom Rüttelgerät (17) in einer horizontalen Ebene hin- und herbewegt oder um die sich vertikal erstreckende Längsachse des Tiegels (5) hin- und hergedreht wird.

4. Vorrichtung nach Anspruch 2, **dadurch gekennzeichnet**, daß der Rechen oder Rührer (19) als Gitter oder Rost ausgebildet ist.

5. Vorrichtung nach Anspruch 3, **dadurch gekennzeichnet**, daß die Höhe des ringförmigen Rechens oder Rührers (19) etwa der Dicke der Wärmeisolationsschicht (13) entspricht.

6. Vorrichtung nach einem oder mehreren der Ansprüche 3 bis 5, **dadurch gekennzeichnet**, daß die Bewegung des Rechens oder Rührers (19) durch die Kombination einer Hub-/Senkbewegung mit einer Hin- und Herbewegung und/oder Hin- und Herdrehung gebildet ist.

7. Vorrichtung nach einem oder mehreren der Ansprüche 3 bis 6, **dadurch gekennzeichnet**, daß der obere Rand des Rechens oder Rührers (19) über sich in einer vertikalen Ebene erstreckende Zapfen oder Bolzen (20) an Führungen (21) abgestützt ist, die am oberen Rand (16) des die Kühlschmelze (10) enthaltenden Tiegels (8) vorgesehen sind.

## Claims

1. A process for the directional solidification of a metal melt cast in a casting mould, for example nickel, by moving the casting mould out of a heating chamber and immersing the casting mould in a liquid metal bath which serves as cooling melt and has a lower melting point than the metal melt in the casting mould, for example aluminium, wherein, for sealing between the heating chamber and the casting mould, a floating thermal insulation layer consisting of a flowable material is applied to the cooling metal, and before the casting mould penetrates the thermal insulation layer and is immersed in the cooling melt, the heating chamber or cooling melt is displaced to such an extent that the heating chamber contacts the thermal insulation layer or is immersed therein, characterised in that the thermal insulation layer is vigorously moved or stirred by a motor driven rake, paddle or agitator.

2. A device for the directional solidification of a metal melt cast in a casting mould (5), for example nickel, by moving the casting mould (5) out of a heating chamber (6) and immersing the casting mould (5) in a liquid metal bath (10) which serves as cooling melt and has a lower melting point than the metal melt in the casting mould (5), for example an aluminium melt bath, wherein, for sealing between the heating chamber (6) and the casting mould (5) a floating thermal insulation layer (13) consisting of a flowable material is applied to the cooling melt (10), and before the casting mould penetrates the thermal insulation layer (13) and is immersed in the cooling melt (10), the heating chamber (6) or the cooling melt (10) is displaced to such an extent that the heating chamber (6) contacts the thermal insulation layer (13) or is immersed therein, characterised by a rake or agitator (19) which is immersed in the thermal insulation layer (13) and is moved by a jolter or vibration generator (17), the jolter or vibration generator (17) being permanently arranged on the upper rim (16) of the crucible (8) for the cooling melt (10) and the rake or agitator (19) being actively connected to the reciprocating driven element (18) of the jolter or vibration generator (17).

3. A device according to Claim 2, characterised in that the rake or agitator (19) has the form of a ring (19) which surrounds the casting mould (5) and which, by the jolter (17), is moved back and forth in a horizontal plane or is rotated back and forth about the vertically extending longitudinal axis of the crucible (5).

4. A device according to Claim 2, characterised in that the rake or agitator (19) has the form of a grid or grating.

5. A device according to Claim 3, characterised in that the height of the ring-shaped rake or agitator (19) corresponds approximately to the thickness of the thermal insulation layer (13).

6. A device according to one or more of Claims 3 to 5, characterised in that the movement of the rake or agitator (19) is formed by the combination of a lifting/lowering movement with a back and forth movement and/or back and forth rotation.

7. A device according to one or more of Claims 3 to 6, characterised in that the upper edge of the rake or agitator (19) is supported, via pins or bolts (20) extending in a vertical plane, on guides (21) which are provided on the upper rim (16) of the crucible (8) containing the cooling melt (10).

## Revendications

1. Procédé pour la solidification dirigée d'un métal en fusion, par exemple du nickel, coulé dans un moule, par déplacement sortant du moule hors d'une chambre de chauffe et par plongée du moule dans un bain de métal liquide servant de bain de refroidissement, dont le point de fusion est inférieur à celui du métal en fusion dans le moule, par exemple de l'aluminium, dans lequel on apporte une couche d'isolation thermique constituée par un matériau fluide flottant sur le bain de refroidissement pour assurer un étanchement entre la chambre de chauffe et le moule, et avant que le moule traverse la couche d'isolation thermique et plonge dans le bain de refroidissement, on déplace la chambre de chauffe ou le bain de refroidissement aussi loin que la chambre de chauffe touche la couche d'isolation thermique ou plonge dans celle-ci, caractérisé en ce que la couche d'isolation thermique est vivement remuée ou mise en tourbillons par un râteau, par une pale ou par un agitateur à entraînement motorisé.

2. Dispositif pour la solidification dirigée de métal en fusion, par exemple du nickel, coulé dans un moule (5), par déplacement sortant du moule (5) hors d'une chambre de chauffe (6) et par plongée du moule (5) dans un bain de métal liquide (10) servant de bain de refroidissement, dont le point de fusion est inférieur à celui du métal en fusion dans le moule (5), par exemple un bain de fonte d'aluminium, dans lequel une couche d'isolation thermique (13) constituée par un matériau fluide flottant est apportée sur le bain de refroidissement (10) pour assurer un étanchement entre la chambre de chauffe (6) et le moule (5), et avant que le moule traverse la couche d'isolation thermique (13) et plonge dans le bain de refroidissement (10), la chambre de chauffe (6) ou le bain de refroidissement (10) est déplacé(e) aussi loin que la chambre de chauffe (6) touche la couche d'isolation thermique (13) ou plonge dans celle-ci, caractérisé par un râteau ou par un agitateur (19) plongeant dans la couche d'isolation thermique (13) et remué par un vibreur ou par un générateur d'oscillations (17), le vibreur ou le générateur d'oscillations (17) étant fermement agencé au niveau du bord supérieur (16) du creuset (8) pour le bain de refroidissement (10), et en ce que le râteau ou mélangeur (19) est en liaison d'action avec l'organe mené (18), en déplacement en va-et-vient, du vibreur ou générateur d'oscillations (17).

3. Dispositif selon la revendication 2, caractérisé en ce que le râteau ou mélangeur (19) est réalisé sous forme d'un anneau (19) qui entoure le moule (5) et qui est déplacé en va-et-vient dans un plan horizontal par le vibreur (17) ou tourné en va-et-vient autour de l'axe longitudinal vertical du creuset (8).

4. Dispositif selon la revendication 2, caractérisé en ce que le râteau ou mélangeur (19) est réalisé sous forme de treillis ou de grille.

5. Dispositif selon la revendication 3, caractérisé en ce que la hauteur du râteau ou mélangeur annulaire (19) correspond approximativement à l'épaisseur de la couche d'isolation thermique (13).

6. Dispositif selon l'une ou plusieurs des revendications 3 à 5, caractérisé en ce que le mouvement du râteau ou mélangeur (19) est réalisé par la combinaison d'un mouvement de soulèvement et d'abaissement avec une translation en va-et-vient et/ou une rotation en va-et-vient.

7. Dispositif selon l'une ou plusieurs des revendications 3 à 6, caractérisé en ce que le bord supérieur du râteau ou mélangeur (19) est appuyé contre des guidages (21) par l'intermédiaire de tenons ou goujons (20) s'étendant dans un plan vertical, lesdits guidages étant prévus sur le bord supérieur (16) du creuset (8) contenant le bain de refroidissement (10).
